# EUROPÄISCHE PATENTSCHRIFT

(11) **EP 3 105 786 B1**
(45) Veröffentlichungstag und Bekanntmachung des Hinweises auf die Patenterteilung: **03.04.2019**
(21) Anmeldenummer: 15704012.2
(22) Anmeldetag: 12.02.2015
(51) Int. Cl.: H01L 23/495

(54) **VERFAHREN ZUR HERSTELLUNG EINER BONDBAREN BESCHICHTUNG AUF EINEM TRÄGERBAND**
METHOD FOR PRODUCING A BONDABLE COATING ON A SUPPORT STRIP
PROCÉDÉ DE RÉALISATION D'UN REVÊTEMENT CÂBLABLE PAR FIL SUR UNE BANDE SUBSTRAT

(30) Priorität: 14.02.2014 DE 102014101882
(43) Veröffentlichungstag der Anmeldung: 21.12.2016
(73) Patentinhaber: Heraeus Deutschland GmbH & Co. KG, 63450 Hanau (DE)
(72) Erfinder: SCHMIDT, Joachim-Franz, 63589 Linsengericht (DE); NEUBAUER, Marcel, 63452 Hanau (DE)
(74) Vertreter: Schultheiss & Sterzel Patentanwälte PartG mbB
(86) Internationale Anmeldenummer: PCT/EP2015/053006
(87) Internationale Veröffentlichungsnummer: WO 2015/121367

(56) Entgegenhaltungen:
- DE-A1- 3 631 119
- DE-A1- 4 229 270

## Beschreibung

Die Erfindung betrifft ein Verfahren zur Herstellung einer bondbaren Beschichtung auf einem Trägerband sowie ein mit einem solchen Verfahren beschichtetes Trägerband.

In der Leistungselektronik werden kupferbasierte Bänder zur elektronischen Verbindung von Leistungsbauteilen mit Bonddrähten verwendet. Es ist aus der DE 42 29 270 A1 und der DE 10 2008 025 664 A1 bekannt, bondfähige Beschichtungen durch Walzen mit einem Trägerband zu verbinden. So schlagen beispielsweise die EP 0 027 520 A1 und die US 4,521,257 A vor, Kupfer-ZinnLegierungen als Trägermaterialien einzusetzen. Nachteilig ist an diesem Material, dass eine höhere Festigkeit des Trägermaterials und geringere Kosten für das Trägermaterial gewünscht werden. Kostengünstigere Kupfer-Zink-Legierungen haben jedoch den Nachteil, dass diese durch den hohen Zinkgehalt die aluminiumbasierte Bondschichten und Bonddrähte vergiften können und dabei die Verbindung beeinträchtigen.

Der Trend zu immer leistungsfähigeren, kupferbasierten Werkstoffen in der Leistungselektronik, die im Speziellen ein gutes Relaxationsvermögen und eine hohe Festigkeit bei gleichzeitiger guter elektrischer Leitfähigkeit benötigen, bewirkt eine Verschiebung von Bronzewerkstoffen hin zu ausscheidungsfähigen Werkstoffen. Sowohl bei den günstigeren Kupfer-Zink-Legierungen als auch bei anderen kupferbasierten Werkstoffen wurde festgestellt, dass sich die Bonddrähte von den Bondflächen lösen können, wobei die Bondflächen dabei ausreißen können.

Die Aufgabe der Erfindung besteht also darin, die Nachteile des Stands der Technik zu überwinden. Insbesondere soll ein Verfahren zur Herstellung eines Trägerbands und ein Trägerband gefunden werden, das den Anforderungen an Trägerbändern für hohe Leistungen genügt, ohne dass es dabei zu einem ungewollten Ausschuss bei der Herstellung beziehungsweise bei den damit hergestellten elektronischen Bauteilen kommt. Dabei soll insbesondere eine Vergiftung der Bondfläche mit schädlichen Atomen und ein abreißen oder eine Schädigung der Verbindung des Bonddrahts mit der Oberfläche beziehungsweise der Bondoberfläche mit dem Trägerband vermieden werden. Gleichzeitig sollen möglichst kostengünstige Materialien als Trägerband einsetzbar sein.

Die Aufgaben der Erfindung werden gelöst durch ein Verfahren zur Herstellung einer bondbaren Beschichtung auf einem metallischen Trägerband aus einer Messinglegierung mit wenigstens 15 Gew% Zink oder einer Kupferbasislegierung enthaltend zumindest 0,03 Gew% Titan, Chrom, Zirkon und/oder Kobalt, bei dem in einem einzigen Arbeitsschritt eine bondbare metallische Funktionsschicht aus Aluminium oder einer Aluminiumbasislegierung und eine metallische Zwischenschicht auf das metallische Trägerband mit einem Walzplattierungsverfahren aufgebracht und verbunden werden, wobei die Zwischenschicht vollständig zwischen der Funktionsschicht und dem metallischen Trägerband angeordnet wird, so dass keine Verbindung der Funktionsschicht mit dem metallischen Trägerband entsteht.

Um bondfähig zu sein, ist die Funktionsschicht dafür vorgesehen, dass sie mit einem Bonddraht verbunden werden kann, vorzugsweise mit einem Bonddraht aus Aluminium oder einer Aluminium-Basis-Legierung verbunden werden kann. Es können alternativ auch Bonddrähte aus Gold oder eine Goldlegierung mit der Funktionsschicht verbunden werden beziehungsweise verbindbar sein.

Erfindungsgemäß bevorzugte Legierungen für das Trägerband sind beispielsweise CuCrZr (UNS: C18400), CuZr0,1 (UNS: C15100), CuCrSiTi (UNS: C18070), CuCrAgFeTiSi (UNS: C18080), CuSnCrNiTi (UNS: C18090) und CuNi1 Co1 Si (UNS: C70350), die als Materialien für ein kostengünstiges und mechanisch robustes Trägerband besonders geeignet sind.

Bei solchen Verfahren kann erfindungsgemäß vorgesehen sein, dass als metallische Funktionsschicht eine Aluminium-Silizium-Legierung verwendet wird.

Solche Aluminium-Silizium-Legierungen lassen sich besonders gut und stabil mit den gebräuchlichen aluminiumbasierten Bonddrähten verbinden.

Mit einer Weiterentwicklung des erfindungsgemäßen Verfahrens wird auch vorgeschlagen, dass als metallische Zwischenschicht bevorzugt Kupfer oder eine Kupfer-Basislegierung oder Nickel oder eine Nickel-Basislegierung verwendet wird.

Dabei werden Kupfer und Kupfer-Basislegierungen aufgrund der geringeren Kosten im Vergleich zu Nickel und Nickel-Basislegierungen erfindungsgemäß bevorzugt. Die Legierungen oder die Metalle sind bevorzugt bis auf Verunreinigungen frei von Zink. Solche Zwischenschichten sind gut zum Abfangen von Zink-Atomen, das heißt als Diffusionssperrschicht geeignet. Des Weiteren ist es vorteilhaft, wenn die freie Oberfläche des Trägerbands über den Bereich der Position der Funktionsschicht abgedeckt ist, da in diesem Bereich dann beim Glühen des beschichteten Trägerbands kein Zink abdampfen und sich auf der Funktionsschicht niederschlagen kann. Ein Zinkniederschlag wirkt sich negativ auf die Bondfähigkeit der Funktionsschicht aus. Gleichzeitig ist auch eine mechanisch stabile Verbindung der aluminiumbasierten Funktionsschicht zu einer Trägerschicht aus einer Kupferbasislegierung enthaltend zumindest 0,03 Gew% Titan, Chrom, Zirkon und/oder Kobalt mit einer solchen Zwischenschicht herstellbar.

Es kann erfindungsgemäß ferner vorgesehen sein, dass die metallische Funktionsschicht und die metallische Zwischenschicht als Bänder auf das metallische Trägerband aufgelegt werden, wobei das Band für die Zwischenschicht zwischen dem Band für die Funktionsschicht und dem Trägerband angeordnet wird und die aufeinander gelegten Bänder anschließend mit dem Walzplattierungsverfahren miteinander verbunden werden.

Mit diesem Verfahren lässt sich eine industrielle Massenfertigung besonders einfach umsetzen. Das erzeugte beschichtete Trägerband kann abschließend in Streifen der für die bei der Anwendung der Trägerstruktur gewünschte Breite und Länge geschnitten werden.

Bei einem erfindungsgemäßen Verfahren mit der Anwendung von Bändern als Ausgangsprodukt für die Schichten und das Trägerband kann wiederum vorgesehen sein, dass das metallische Trägerband, die metallische Funktionsschicht und die metallische Zwischenschicht vor dem Zusammenfügen als aufgerollte Endlosbänder vorliegen, die zum Verbinden der Schichten abgerollt werden, um die Bänder zueinander zu positionieren, wobei die Verbindung der Bänder durch ein kontinuierliches Walzplattieren der Bänder zwischen Walzen erfolgt. Dabei kann vorgesehen sein, dass die Bänder über Rollen zugeführt werden.

Unter einem Endlosband ist erfindungsgemäß ein Band mit einer Länge von wenigstens 1 m zu verstehen bevorzugt ein Band mit einer Länge zwischen 5 m und 100 m. Das Band wird selbstverständlich also nicht wirklich endlos sein. Auch diese Verfahrensvariante dient der weiteren Vereinfachung einer Massenfertigung.

Mit einer Weiterentwicklung des erfindungsgemäßen Verfahrens wird auch vorgeschlagen, dass das mit der Zwischenschicht und der Funktionsschicht verbundene Trägerband als Endlosband aufgerollt wird.

Ein derart aufgerolltes beschichtetes Trägerband kann anschließend mit Fördereinrichtungen weiterverarbeitet werden. Das mit dem Endlosband erzeugte Vorprodukt dient also dazu, eine anschließende Bestückung für eine Massenproduktion zu vereinfachen.

Des Weiteren kann zur Sicherstellung einer stabilen mechanischen Verbindung des Trägerbands mit der Zwischenschicht auch vorgesehen sein, dass das Trägerband vor dem Verbinden mit den anderen Schichten gereinigt wird, insbesondere mechanisch mit Bürsten und/oder chemisch gereinigt wird, bevorzugt vor dem Auflegen der Zwischenschicht gereinigt wird, wobei bevorzugt auch das Band für die Zwischenschicht und/oder das Band für die Funktionsschicht vor dem Verbinden gereinigt wird, insbesondere mechanisch mit Bürsten und/oder chemisch gereinigt wird.

Hierdurch kann sichergestellt werden, dass vor dem Verbinden der Zwischenschicht und der Funktionsschicht mit dem Trägerband keine anhaftenden Verunreinigungen die mechanische Stabilität der Beschichtungen nicht negativ beeinflussen.

Anstatt mit Bürsten oder zusätzlich zur Reinigung mit Bürsten kann auch ein Luftstrom zur Entfernung von Rückständen, wie Spänen, die durch einen Schälprozess entstanden sein können, auf die Oberfläche der Bänder geblasen werden.

Es kann erfindungsgemäß auch vorgesehen sein, dass das mit der Walzplattierung beschichtete Trägerband eine Dicke zwischen 0,5 mm und 2 mm aufweist. Die Dicke der Zwischenschicht nach dem Walzplattieren beträgt bevorzugt zwischen 5 µm und 30 µm. Die Dicke der Funktionsschicht beträgt vorzugsweise zwischen 10 µm und 50 µm.

Des Weiteren kann vorgesehen sein, dass das mit der Funktionsschicht beschichtete Trägerband als Substrat zur elektrischen Kontaktierung von Leistungsbauteilen mit Bonddrähten verwendet wird, bevorzugt zur Herstellung von Schwachstromkontakten.

Die der Erfindung zugrundeliegenden Aufgaben werden auch gelöst durch ein beschichtetes Trägerband hergestellt mit einem solchen Verfahren, bei dem auf dem Trägerband die Zwischenschicht angeordnet und befestigt ist und auf der Zwischenschicht die Funktionsschicht angeordnet und befestigt ist.

Hierdurch kann sichergestellt werden, dass die Zwischenschicht vollständig als stabilisierendes und chemisch isolierendes Verbindungselement (als Diffusionssperre) zwischen der Funktionsschicht und dem Trägerband angeordnet ist. Dadurch wird erreicht, dass es an keiner Stelle der Funktionsschicht zu einer Vergiftung mit Zink kommt oder zu einer Schwächung der mechanischen Verbindung zum Trägerband aufgrund von in der Oberfläche des Trägerbands vorhandenen Ausscheidungen der genannten Legierungselemente als Oxide oder als Verbindungen der Elemente untereinander.

Bei solchen Trägerbändern kann auch vorgesehen sein, dass das metallische Trägerband eine Messinglegierung mit wenigstens 15 Gew% Zink oder eine Kupferbasislegierung mit wenigstens 0,03 Gew% Titan, Chrom, Zirkon und/oder Kobalt ist.

Bei diesen Legierungen wirkt sich die Zwischenschicht entweder als Diffusionsbarriere gegen Zink-Atomen oder als Überbrückung der Ausscheidungen der genannten Legierungselemente als Oxide oder von Verbindungen der Elemente untereinander in der Oberfläche des Trägerbands zur mechanischen Stabilisierung der mechanischen Verbindung der Funktionsschicht zur Trägerschicht positiv auf die Eigenschaften des beschichteten Trägerbands aus.

Ferner kann auch vorgesehen sein, dass die metallische Funktionsschicht Aluminium oder eine Aluminium-Basislegierung ist, bevorzugt eine Aluminium-Silizium-Legierung ist.

Solche Aluminium-Silizium-Legierungen oder das reine Aluminium lassen sich besonders gut und stabil mit den gebräuchlichen aluminiumbasierten Bonddrähten verbinden.

Des Weiteren kann vorgesehen sein, dass das beschichtete Trägerband als Substrat zur elektrischen Kontaktierung von Leistungsbauteilen mit Bonddrähten geeignet ist, bevorzugt zur Herstellung von Schwachstromkontakten.

Schließlich kann erfindungsgemäß auch vorgesehen sein, dass die metallische Zwischenschicht Kupfer oder eine Kupfer-Basislegierung oder Nickel oder eine Nickel-Basislegierung ist.

Der Erfindung liegt die überraschende Erkenntnis zugrunde, dass es durch das Einbringen einer Zwischenschicht zwischen die bondfähige Funktionsschicht und das Trägerband gelingt, die Zwischenschicht als Stützschicht zur Befestigung der Funktionsschicht aufzubringen, wobei die Zwischenschicht in der Oberfläche des Trägerbands vorhandene Schwachstellen, wie Titanoxid-Einschlüsse oder andere oxydische Einschlüsse überbrückt und somit für eine stabile Verbindung der bondfähigen Funktionsschicht zum Trägerband sorgt, und/oder die Zwischenschicht als Diffusionssperre gegen ein Eindiffundieren von störenden Atomen wie insbesondere Zink-Atome aus dem Trägerband in die Funktionsschicht dient, um die Funktionsschicht vor den schädlichen Einflüssen dieser Atome zu schützen. Dadurch wird die Anwendung von Trägerbändern aus kostengünstigeren und/oder aufgrund ihrer physikalischen Eigenschaften besser geeigneten Materialien möglich, ohne dass es zu einem höheren Ausschuss bei der Herstellung oder zu einer Verschlechterung der Verbindung der Bonddrähte mit der Funktionsoberfläche beziehungsweise dem Substrat kommt. Dadurch, dass der Schichtverbund in einem einzigen Arbeitsschritt durch Walzplattieren erzeugt wird, ist das beschichtete Trägerband mit einem geringen Kostenaufwand herstellbar.

Es wurde im Rahmen der vorliegenden Erfindung festgestellt, dass geeignete Kupferwerkstoffe für Leistungselektronik, die typischerweise mit den Elementen Cr, Ti, Zr und Co (und/oder gegebenenfalls anderen Elementen) legiert sind, je nach Legierungsgehalt zu ungelösten Metalleinschlüssen beziehungsweise Metalloxideinschlüssen neigen. Beispielhaft hierfür kann für den Werkstoff K75® (eine Kupfer-Basislegierung mit 0,3 Gew% Chrom, 0,1 Gew% Titan, 0,02 Gew% Silizium und dem Rest Kupfer) das Auftreten von TiO₂-Einschlüssen genannt werden, die einen Durchmesser beziehungsweise eine Längsstrukturierung von zum Beispiel 10 µm bis 60 µm im Querschnitt aufweisen. In Anschliffen solcher Werkstoffe wie K75® sind zellenförmige, ungelöste TiO₂-Einschlüssen zu finden. Liegen diese Partikel im oberflächennahen Bereich vor, können diese durch die in einem Walzplattierprozess stattfindende Streckung an die Oberfläche gelangen. Dies kann auf Grund einer lokalen Nichthaftung mit einem erhöhten Risiko zu einem Haftausfall beziehungsweise einem Ausfall einer Bondverbindung führen. Entsprechend ergibt sich aus dieser erfindungsgemäßen Erkenntnis die Forderung nach einen Lösungsansatz für diese Problematik.

Ferner wird seitens der Anwender solcher Trägerbänder eine Reduzierung der Kosten von walzplattierten Bändern gefordert. Eine gute Möglichkeit bietet dabei der kostengünstigere Einsatz von stark zinkhaltigen Messinglegierungen (Zn-Gehalt zumindest 15%). Solche Kupfer-Zink-Legierungen bieten eine signifikante Kostenersparnis des Trägerbandes im Vergleich zu CuSn6 (Kupfer-Zinn-Bronze). Je nach durchgeführter Glühbehandlung kann der hohe Zinkgehalt dabei allerdings zu einer Beaufschlagung des niedrigschmelzenden Zinks auf als auch einer Diffusion des Zinks in das Bondsubstrat führen und somit eine Verschlechterung der Bondeigenschaften bewirken. Auch hierfür wird erfindungsgemäß ein neuer Lösungsansatz bereitgestellt.

Das Verfahren des Einbringens einer Diffusionssperrschicht beziehungsweise Stützschicht als Zwischenschicht kann erfindungsgemäß für eine Reihe von walzplattierten Werkstoffkombinationen Anwendung finden. Dabei kann zwischen einer ganzflächigen und einer selektiven Zwischenschicht unterschieden werden. Ganzflächige Zwischenschichten dienen vorrangig als Diffusionssperre und Haftvermittler, wobei selektive Zwischenschichten bisher speziell für Connectorbänder zur Schichtdickenreduzierung über ein Vordouble eingebracht werden. In beiden Fällen wird bevorzugt Nickel (Ni) oder eine Ni-Basislegierung verwendet.

Das Vordouble ist eine Art Vorplattierung von insbesondere edelmetallhaltigen Funktionswerkstoffen, die dazu dient, dass die Funktionsschicht nach dem eigentlichen Plattieren möglichst dünn erzeugt beziehungsweise aufgewalzt werden kann und somit Edelmetall eingespart werden kann. Die Vorplattierung wird in der Regel in einem separaten Schritt durchgeführt.

Das Verfahren des Inline-Direktplattierens von Zwischenschichten als Diffusionsausgleichsschicht beziehungsweise Haftvermittlungsschicht speziell für das Anwendungsfeld von selektiv walzplattierten und bondfähigen Funktionsoberflächen ist dabei ein komplett neuer Ansatz. Diese Zwischenschicht wird benötigt, um die voran beschriebenen Effekte (Vergiftung oder Beeinträchtigung der Funktionsschicht und Oxyd-Einschlüsse an der Oberfläche des Trägerbands), die im Rahmen der vorliegenden Erfindung erkannt wurden, zu kompensieren beziehungsweise zu vermeiden. Das gleichzeitige Plattieren der Zwischenschicht ermöglicht dabei eine Reduzierung der zusätzlichen Prozesskosten und ermöglicht somit die Anwendung von neuen Trägerwerkstoffen für bondbare Funktionsoberflächen.

Um die voran beschriebenen Effekte (Vergiftung / Beeinträchtigung und Oxyd-Einschlüsse) der oberflächennahen, ungelösten Partikel (Oxyd-Einschlüsse) beziehungsweise eine Beeinflussung der bondfähigen Oberflächen durch Zinkpartikel zu vermeiden, wird erfindungsgemäß Inline, also während des eigentlichen Plattierungsprozesses, die benötigte Funktionszwischenschicht gleichzeitig plattiert. Dabei ist sowohl eine selektive als auch vollflächige (über die gesamte Breite des Trägerbands) Zwischenschicht möglich, wobei die selektive Variante bevorzugt wird. Die Breite der selektiven Zwischenschicht sollte mindestens gleichgroß der Breite der bondfähigen Funktionsoberfläche sein, wobei ein beidseitiger Überstand der Zwischenschicht von mindestens 0,5 mm aus Haftungsgründen bevorzugt wird.

Als Werkstoffe dieser Zwischenschicht kommen vorrangig Kupfer (Cu) oder Kupfer-Basislegierungen als auch Nickel (Ni) oder Nickel-Basislegierungen in Frage. Die eingebrachte Zwischenschicht wirkt für die ausscheidungswirkenden Trägersubstrate auf Grund ihrer höheren (Haft-)Festigkeit und Steifigkeit als Haftvermittler und kann lokale Fehlstellen besser absorbieren.

Entsprechend zeigt die eingebrachte Zwischenschicht für hochzinkhaltige Messingträgerwerkstoffe ihre Wirkung als Diffusionsausgleichsschicht für den im Herstellprozess stattfindenden, kurzzeitigen Glüh- beziehungsweise Diffusionsprozess (beispielsweise t = 5 bis 10 min bei T = 350 bis 500°C). Der zeit- und temperaturabhängige Diffusionsprozess des Zinks in die bondfähige Funktionsoberfläche, bevorzugt eine Aluminium-Silizium-Legierung (AISi), wird verhindert beziehungsweise findet vorrangig in der Zwischenschicht statt.

Das Inline-Direktplattieren einer speziell selektiven Zwischenschicht als Diffusionsausgleichsschicht beziehungsweise Haftvermittlungsschicht für bondbare Funktionsoberflächen bietet im Vergleich zu dem Standardprozess mit der Verwendung eines Vordoubles die Einsparung von aufwendigen Prozessschritten. Die Verwendung dieser Zwischenschicht ermöglicht des Weiteren den kostengünstigen Einsatz von neuen Träger-Werkstoffen bei gleichzeitiger Gewährleistung einer guten Haftung der bondfähigen Funktionsoberfläche beziehungsweise Funktionsschicht.

Die Anwendung einer inline-plattierten selektiven Zwischenschicht als Haftvermittler kann beispielsweise mit dem Trägerwerkstoff K75® als Trägerband durchgeführt werden.

Ein mit einem erfindungsgemäßen Verfahren hergestelltes beschichtetes Trägerband und ein erfindungsgemäßes beschichtetes Trägerband kann bevorzugt im Bereich der Pressfit-Verbindungstechnik sowie in neuen Anwendungen der Leistungselektronik Anwendung finden, in welchem leistungsfähigere, kupfer- und ausscheidungsbasierende Werkstoffe eingesetzt werden sollen. Solche ausscheidungsbasierenden Werkstoffe sind aufgrund ihres speziell Relaxationsvermögens und ihrer hohen Festigkeit bei gleichzeitiger guter elektrischer Leitfähigkeit für die Anwendung zunehmend interessant. Des Weiteren ist die Verwendung einer Diffusionsausgleichschicht speziell für hochzinkhaltige Messinglegierungen im Low-Cost-Bereich von Drucksensoren möglich.

Im Folgenden werden weitere Ausführungsbeispiele der Erfindung anhand von drei schematisch dargestellten Figuren erläutert, ohne jedoch dabei die Erfindung zu beschränken. Dabei zeigt:
Figur 1: eine schematische Querschnittansicht einer Vorrichtung zum Umsetzen eines erfindungsgemäßen Verfahrens;
Figur 2: eine schematische Querschnittansicht eines erfindungsgemäß walzplattierten beschichteten Trägerbands; und
Figur 3: eine vergrößerte schematische Querschnittansicht des walzplattierten beschichteten Trägerbands nach Figur 2 mit verbundenem Bonddraht.

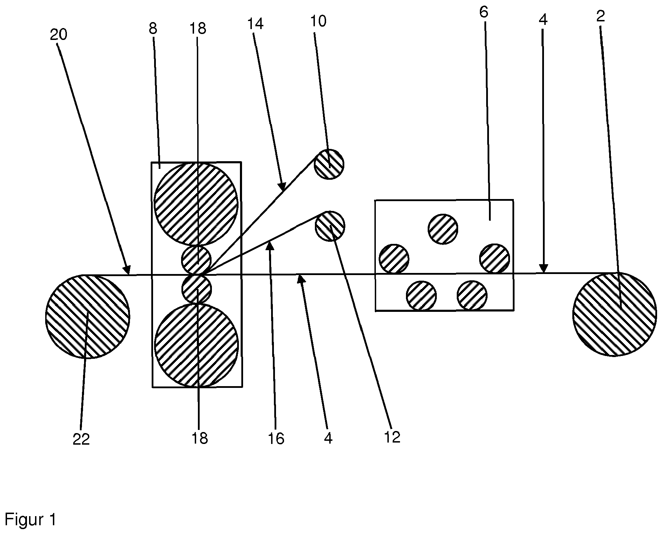

Figur 1 zeigt eine schematische Querschnittansicht einer Vorrichtung zum Umsetzen eines erfindungsgemäßen Verfahrens. Auf einer Haspel 2 oder einer Rolle 2 ist ein Trägerband 4 aus CuZn20 oder einem anderen Messing mit wenigstens 15 Gew% Zink oder aus einer ausscheidungshärtenden Kupfer-Basislegierung enthaltend zumindest 0,03 Gew% Titan, Chrom, Zirkon und/oder Kobalt. Beispielsweise und besonders bevorzugt wird eine Wieland-K75® Kupfer-Basislegierung mit 0,3 Gew% Chrom, 0,1 Gew% Titan, 0,02 Gew% Silizium und dem Rest Kupfer verwendet. Als Material für das Trägerband 4 kommen dabei insbesondere die Legierungen CuCrZr (UNS: C18400), CuZr0,1 (UNS: C15100), CuCrSiTi (UNS: C18070), CuCrAgFeTiSi (UNS: C18080), CuSnCrNiTi (UNS: C18090) und CuNi1Co1Si (UNS: C70350) in Frage.

Das aufgerollte Trägerband 4 wird von der Haspel 2 abgerollt und durch eine Bürstmaschine 6 oder eine andere Vorrichtung zum Reinigen der zu beschichtenden Oberfläche des Trägerbands 4 geleitet. Anschließend wird das gereinigte Trägerband 4 einer Walz-Plattier-Maschine 8 zugeführt.

Von einer zweiten Haspel 10 oder einer zweiten Rolle 10 wird ein Band 14 für eine Funktionsschicht abgerollt und von einer dritten Haspel 12 oder einer dritten Rolle 12 wird ein Band 16 für eine Zwischenschicht angerollt. Das Band 14 für die Funktionsschicht besteht aus einer Aluminium-Silizium-Legierung, während das Band 16 für die Zwischenschicht aus einer Nickel-Basislegierung oder einer Kupfer-Basislegierung besteht. Die Bänder 14, 16 werden ebenfalls der Walz-Plattier-Maschine 8 zugeführt. Dabei wird das Band 16 für die Zwischenschicht auf das Trägerband 4 aufgelegt und das Band 14 für die Funktionsschicht wird auf das Band 16 für die Zwischenschicht aufgelegt. Das Band 16 für die Zwischenschicht ist zumindest genauso breit wie das Band 14 für die Funktionsschicht oder breiter.

Anschließend werden die Bänder 4, 14, 16 mit Hilfe zweier Walzen 18 der Walz-Plattier-Maschine 8 unter Druck und, wenn gewünscht bei einer erhöhten Temperatur, beispielsweise bei 200°C bis 600°C, aufeinander gewalzt und plattiert. Es können erfindungsgemäß auch mehr als ein Band 16 für die Zwischenschicht und mehr als ein Band 14 für die Funktionsschicht parallel zueinander gefördert werden und mit dem Trägerband 4 verbunden werden, so dass die erzeugten Funktionsschichten und Zwischenschichten nebeneinander auf dem Trägerband 4 angeordnet sind. Es ist ferner möglich, das Trägerband 4 vollständig mit nur einem sehr breiten Band 16 für die Zwischenschicht zur Herstellung einer das Trägerband 4 weitgehend oder vollständig abdeckenden Zwischenschicht abzudecken und auf der Zwischenschicht mehrere nebeneinander angeordnete Funktionsschichten durch Auflegen und Walzplattieren von mehreren nebeneinander platzierten Bändern 14 für die Funktionsschicht herzustellen.

Die Bändern 4, 14, 16 werden durch die Walz-Plattier-Maschine 8 gefördert, dort miteinander verbunden und anschließend wird das entstehende beschichtete Trägerband 20 auf einer weiteren Haspel 22 oder Rolle 22 wieder aufgerollt. Die Verwendung solcher Endlosbänder, die nicht tatsächlich endlos sind, sondern zwischen einem Meter und einigen hundert Meter lang sein können, hat den Vorteil, dass eine industrielle Massenproduktion ohne weiteres möglich ist.

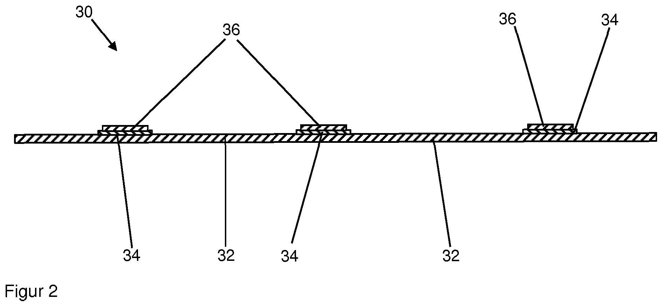

Figur 2 zeigt eine schematische Querschnittansicht eines erfindungsgemäß walzplattierten beschichteten Trägerbands 30, das beispielsweise mit einem Verfahren hergestellt werden kann, wie es zu Figur 1 erläutert wurde.

Auf dem Trägerband 32 sind drei Streifen einer Zwischenschicht 34 aus einer Nickel-Basislegierung oder einer Kupfer-Basislegierung durch Walzplattieren aufgebracht worden. Auf diesen drei Streifen der Zwischenschicht 34 ist wiederrum jeweils eine Funktionsschicht 36 aus Aluminium oder einer Aluminium-Silizium-Legierung mit Walzplattieren befestigt.

Die Zwischenschicht 34 wurde in einem einzigen Arbeitsschritt sowohl mit dem Trägerband 32 als auch mit der Funktionsschicht 36 verbunden. Das Trägerband 32 besteht aus einer ausscheidungshärtenden Kupfer-Basis-Legierung, wie beispielsweise CuCrZr (UNS: C18400), CuZr0,1 (UNS: C15100), CuCrSiTi (UNS: C18070), CuCrAgFeTiSi (UNS: C18080), CuSnCrNiTi (UNS: C18090) oder CuNi1Co1Si (UNS: C70350) oder aus einem Messing mit einem Zink-Anteil von wenigstens 15 Gew%. Die Zwischenschichten 34 sind breiter als die jeweils auf ihr befestigte Funktionsschicht 36, beispielsweise mindestens 0,5 mm breiter, wobei ein beidseitiger Überstand der Zwischenschicht bevorzugt ist. Eventuell in dem Trägerband 32 enthaltene oxydische Einschlüsse, wie Titanoxid, Chromoxid und/oder Zirkonoxid oder metallische Verbindungen, wie Verbindungen aus Titan, Chrom und/oder Zirkonium, die sich an der oberen, zur Bondfläche hin ausgerichteten Fläche des Trägerbands 32 befinden und die ein Bonden mit einem Bonddraht (nicht gezeigt) beeinträchtigen könnten, werden durch die Zwischenschicht 34 abgedeckt. Dadurch kann eine sichere Verbindung eines Bonddrahts mit der Funktionsschicht 36 und damit mit dem Trägerband 32 erreicht werden, auch wenn in der Oberfläche des Trägerbands 32 störende lokale Oberflächeneinschlüsse vorhanden sind.

Die Dicke der walzplattierten Zwischenschicht 34 liegt zwischen 5 µm und 30 µm. Die Dicke der Funktionsschicht 36 liegt zwischen 10 µm und 50 µm. Die Dicke des gesamten Trägerbands 32 mit der Zwischenschicht 34 und der Funktionsschicht 36 liegt zwischen 0,5 mm und 2 mm.

Wenn eine Messing-Legierung als Trägerband 32 verwendet wird, kann eine Vergiftung oder Beeinträchtigung der Funktionsschicht 36 mit Zink verhindert werden. Die Zwischenschicht 34 dient dann als eine Diffusionssperrschicht, die ein Eindiffundieren von Zink-Atomen in die Funktionsschicht 36 verhindert. Dies bewirkt ebenfalls, dass eine sichere Verbindung eines Bonddrahts mit der Bondoberfläche der Funktionsschicht 36 hergestellt werden kann.

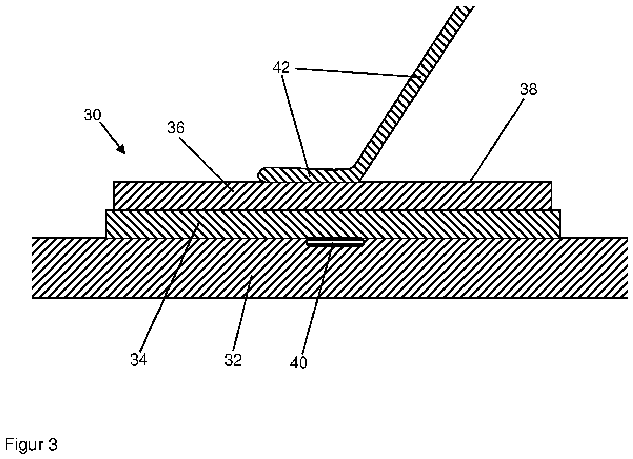

Figur 3 zeigt eine vergrößerte schematische Querschnittansicht des walzplattierten beschichteten Trägerbands 30 nach Figur 2 mit einem mit einer Bondfläche 38 verbundenen Bonddraht 42. In Figur 3 ist beispielhaft ein oxydischer Einschluss 40 (beispielsweise ein Titanoxid-Einschluss) in der Oberfläche des Trägerbands 32 dargestellt, der durch die Zwischenschicht 34 abgedeckt ist. Der Bonddraht 42 ist mit einem bekannten Verfahren mit der Bondoberfläche 38 der Funktionsschicht 36 verbunden worden.

### Bezugszeichenliste

- 2: Haspel / Rolle mit Trägerband
- 4: Trägerband
- 6: Bürstmaschine
- 8: Walz-Plattier-Maschine
- 10: Einlauf bondbare Funktionsschicht / Rolle Funktionsband
- 12: Einlauf Zwischenschicht / Rolle Band für Zwischenschicht
- 14: Band für Funktionsschicht
- 16: Band für Zwischenschicht
- 18: Walze
- 20: Beschichtetes Trägerband
- 22: Haspel / Rolle mit beschichtetem Trägerband
- 30: Beschichtetes Trägerband
- 32: Trägerband
- 34: Zwischenschicht
- 36: Funktionsschicht
- 38: Bondfläche
- 40: Einschluss
- 42: Bonddraht

## Patentansprüche

1. Verfahren zur Herstellung einer bondbaren Beschichtung auf einem metallischen Trägerband (4, 32) aus einer Messinglegierung mit wenigstens 15 Gew% Zink oder einer Kupferbasislegierung enthaltend zumindest 0,03 Gew% Titan, Chrom, Zirkon und/oder Kobalt, bei dem
in einem einzigen Arbeitsschritt eine bondbare metallische Funktionsschicht (14, 36) aus Aluminium oder einer Aluminium-Basislegierung und eine metallische Zwischenschicht (16, 34) auf das metallische Trägerband (4, 32) mit einem Walzplattierungsverfahren aufgebracht und verbunden werden, wobei die Zwischenschicht (16, 34) vollständig zwischen der Funktionsschicht (14, 36) und dem metallischen Trägerband (4, 32) angeordnet wird, so dass keine Verbindung der Funktionsschicht (14, 36) mit dem metallischen Trägerband (4, 32) entsteht.

2. Verfahren nach Anspruch 1, **dadurch gekennzeichnet, dass**
als metallische Funktionsschicht (14, 36) eine Aluminium-Silizium-Legierung verwendet wird.

3. Verfahren nach Anspruch 1 oder 2, **dadurch gekennzeichnet, dass**
als metallische Zwischenschicht (16, 34) Kupfer oder eine Kupfer-Basislegierung oder Nickel oder eine Nickel-Basislegierung verwendet wird.

4. Verfahren nach einem der vorangehenden Ansprüche, **dadurch gekennzeichnet, dass**
die metallische Funktionsschicht (14, 36) und die metallische Zwischenschicht (16, 34) als Bänder (14, 16) auf das metallische Trägerband (4, 32) aufgelegt werden, wobei das Band (16) für die Zwischenschicht (16, 34) zwischen dem Band (14) für die Funktionsschicht (14, 36) und dem Trägerband (4, 32) angeordnet wird und die aufeinander gelegten Bänder (14, 16) anschließend mit dem Walzplattierungsverfahren miteinander verbunden werden.

5. Verfahren nach Anspruch 4, **dadurch gekennzeichnet, dass**
das metallische Trägerband (4, 32), die metallische Funktionsschicht (14, 36) und die metallische Zwischenschicht (16, 34) vor dem Zusammenfügen als aufgerollte Endlosbänder (4, 10, 12) vorliegen, die zum Verbinden der Schichten abgerollt werden, um die Bänder (4, 14, 16) zueinander zu positionieren, wobei die Verbindung der Bänder (4, 14, 16) durch ein kontinuierliches Walzplattieren der Bänder (4, 14, 16) zwischen Walzen (18) erfolgt.

6. Verfahren nach einem der vorangehenden Ansprüche, **dadurch gekennzeichnet, dass**
das mit der Zwischenschicht (16, 34) und der Funktionsschicht (14, 36) verbundene Trägerband (4, 32) als Endlosband (20) aufgerollt wird.

7. Verfahren nach einem der vorangehenden Ansprüche, **dadurch gekennzeichnet, dass**
das Trägerband (4, 32) vor dem Verbinden mit den anderen Schichten (14, 16, 34, 36) gereinigt wird, insbesondere mechanisch mit Bürsten und/oder chemisch gereinigt wird, bevorzugt vor dem Auflegen der Zwischenschicht (16, 34) gereinigt wird, wobei bevorzugt auch das Band (16) für die Zwischenschicht (16, 34) und/oder das Band (14) für die Funktionsschicht (14, 36) vor dem Verbinden gereinigt wird, insbesondere mechanisch mit Bürsten und/oder chemisch gereinigt wird.

8. Verwendung eines mit einem Verfahren nach einem der vorangehenden Ansprüche erzeugten Substrats zur elektrischen Kontaktierung von Leistungsbauteilen mit Bonddrähten (42), bevorzugt zur Herstellung von Schwachstromkontakten.

9. Beschichtetes Trägerband (20, 30) hergestellt mit einem Verfahren nach einem der vorangehenden Ansprüche, **dadurch gekennzeichnet, dass**
auf einem Trägerband (4, 32) aus einer Messinglegierung mit wenigstens 15 Gew% Zink oder einer Kupferbasislegierung enthaltend zumindest 0,03 Gew% Titan, Chrom, Zirkon und/oder Kobalt eine Zwischenschicht (16, 34) angeordnet und mit einem Walzplattierungsverfahren befestigt ist und auf der Zwischenschicht (16, 34) eine Funktionsschicht (14, 36) aus Aluminium oder einer Aluminium-Basislegierung angeordnet und mit einem Walzplattierungsverfahren befestigt ist, wobei die Zwischenschicht (16, 34) vollständig zwischen der Funktionsschicht (14, 36) und dem metallischen Trägerband (4, 32) angeordnet ist, so dass keine Verbindung der Funktionsschicht (14, 36) mit dem metallischen Trägerband (4, 32) besteht.

10. Trägerband (20, 30) nach Anspruch 9, **dadurch gekennzeichnet, dass**
das metallische Trägerband (4, 32) eine Messinglegierung mit wenigstens 15 Gew% Zink oder eine Kupferbasislegierung mit wenigstens 0,03 Gew% Titan, Chrom, Zirkon und/oder Kobalt ist.

11. Trägerband (20, 30) nach einem der Ansprüche 9 oder 10, **dadurch gekennzeichnet, dass**
die metallische Funktionsschicht (14, 36) Aluminium oder eine Aluminium-Basislegierung ist, bevorzugt eine Aluminium-Silizium-Legierung ist.

12. Trägerband (20, 30) nach einem der Ansprüche 9 bis 11, **dadurch gekennzeichnet, dass**
die metallische Zwischenschicht (16, 34) Kupfer oder eine Kupfer-Basislegierung oder Nickel oder eine Nickel-Basislegierung ist.

13. Trägerband (20, 30) nach einem der Ansprüche 9 bis 12, **dadurch gekennzeichnet, dass**
das beschichtete Trägerband (20, 30) als Substrat zur elektrischen Kontaktierung von Leistungsbauteilen mit Bonddrähten (42) geeignet ist, bevorzugt zur Herstellung von Schwachstromkontakten.

## Claims

1. A method for producing a bondable coating on a metallic carrier strip (4, 32) made of a brass alloy with at least 15 wt% zinc or a copper-based alloy containing at least 0.03 wt% titanium, chromium, zirconium and/or cobalt, in which
in a single working step, a bondable metallic functional layer (14, 36) made of aluminum or an aluminum-based alloy and a metallic intermediate layer (16, 34) are placed onto the metallic carrier strip (4, 32) and bonded thereto using a roll cladding method, wherein the intermediate layer (16, 34) is arranged fully between the functional layer (14, 36) and the metallic carrier strip (4, 32), so that no contact between the functional layer (14, 36) and the metallic carrier strip (4, 32) is created.

2. The method according to claim 1, **characterized in that**
an aluminum-silicon alloy is used as the metallic functional layer (14, 36).

3. The method according to claim 1 or 2, **characterized in that**
copper or a copper-based alloy or nickel or a nickel-based alloy is used as the metallic intermediate layer (16, 34).

4. The method according to any one of the preceding claims, **characterized in that** the metallic functional layer (14, 36) and the metallic intermediate layer (16, 34) are placed as strips (14, 16) onto the metallic carrier strip (4, 32), wherein the strip (16) for the intermediate layer (16, 34) is arranged between the strip (14) for the functional layer (14, 36) and the carrier strip (4, 32) and the strips (14, 16) laid one on top of the other are then bonded with each other using the roll cladding method.

5. The method according to claim 4, **characterized in that**
the metallic carrier strip (4, 32), the metallic functional layer (14, 36) and the metallic intermediate layer (16, 34) are present prior to being joined together as rolled up endless strips (4, 10, 12), which are unrolled for bonding the layers in order to position the strips (4, 14, 16) in relation to each other, wherein the bonding of the strips (4, 14, 16) is achieved by continuous roll cladding of the strips (4, 14, 16) between rollers (18).

6. The method according to any one of the preceding claims, **characterized in that** the carrier strip (4, 32) bonded with the intermediate layer (16, 34) and the functional layer (14, 36) is rolled up as an endless strip (20).

7. The method according to any one of the preceding claims, **characterized in that** the carrier strip (4, 32) is cleaned prior to bonding with the other strips (14, 16, 34, 36), in particular cleaned mechanically with brushes and/or chemically, preferably cleaned prior to the placing of the intermediate layer (16, 34), wherein preferably, the strip (16) for the intermediate layer (16, 34) and/or the strip (14) for the functional layer (14, 36) is also cleaned prior to bonding, in particular cleaned mechanically with brushes and/or chemically.

8. Use of a substrate produced by a method according to any one of the preceding for electrically contacting of power components with bonding wires (42), preferably for producing low-current contacts.

9. A coated carrier strip (20, 30) produced using a method according to any one of the preceding claims, **characterized in that**
on a carrier strip (4, 32) made of a brass alloy with at least 15 wt% zinc or a copper-based alloy with at least 0.03 wt% titanium, chromium, zirconium and/or cobalt an intermediate layer (16, 34) is arranged and affixed on the intermediate layer (16, 34) by using a roll cladding method and on the intermediate layer (16, 34) a functional layer (14, 36) is arranged and affixed by using a roll cladding method, wherein the intermediate layer (16, 34) is arranged fully between the functional layer (14, 36) and the metallic carrier strip (4, 32), so that no contact exists between the functional layer (14, 36) and the metallic carrier strip (4, 32).

10. The carrier strip (20, 30) according to claim 9, **characterized in that**
the metallic carrier strip (4, 32) is a brass alloy with at least 15 wt% zinc or a copper-based alloy with at least 0.03 wt% titanium, chromium, zirconium and/or cobalt.

11. The carrier strip (20, 30) according to either of claims 9 or 10, **characterized in that**
the metallic functional layer (14, 36) is aluminum or an aluminum-based alloy, preferably an aluminum-silicon alloy.

12. The carrier strip (20, 30) according to any one of claims 9 to 11, **characterized in that**
the metallic intermediate layer (16, 34) is copper or a copper-based alloy or nickel or a nickel-based alloy.

13. The carrier strip (20, 30) according to any one of claims 9 to 12, **characterized in that**
the coated carrier strip (20, 30) is suitable as a substrate for the electrical contacting of power components with bond wires (42), preferably for producing low current contacts.

## Revendications

1. Procédé de réalisation d'un revêtement soudable sur une bande de support (4, 32) métallique constitué d'un alliage de laiton avec au moins 15 % en poids de zinc ou d'un alliage à base de cuivre contenant au moins 0,03 % en poids de titane, de chrome, de zirconium et/ou de cobalt, chez lequel
une couche fonctionnelle (14, 36) métallique soudable constituée d'aluminium ou d'un alliage à base d'aluminium et une couche intermédiaire (16, 34) métallique sont rapportées et liées en une seule étape de travail sur la bande de support (4, 32) avec un procédé de placage par laminage, la couche intermédiaire (16, 34) étant complètement disposée entre la couche fonctionnelle (14, 36) et la bande de support (4, 32) métallique de sorte qu'il ne se produise aucune liaison de la couche fonctionnelle (14, 36) avec la bande de support (4, 32) métallique.

2. Procédé selon la revendication 1, **caractérisé en ce**
**qu'**en tant que couche intermédiaire (16, 34) métallique, on emploie un alliage d'aluminium et de silicium.

3. Procédé selon la revendication 1 ou la revendication 2, **caractérisé en ce qu'**en tant que couche intermédiaire (16, 34) métallique, on emploie du cuivre ou un alliage à base de cuivre ou du nickel ou un alliage à base de nickel.

4. Procédé selon l'une des revendications précédentes, **caractérisé en ce que** la couche fonctionnelle (14, 36) métallique et la couche intermédiaire (16, 34) métallique sont posées sous forme de bandes (14, 16) sur la bande de support (4, 32) métallique, la bande (16) servant de couche intermédiaire (16, 34) étant disposée entre la bande (14) servant de couche fonctionnelle (14, 36) et la bande de support (4, 32) et les bandes (14, 16) posées l'une sur l'autre sont ensuite reliées avec le procédé de placage par laminage.

5. Procédé selon la revendication 4, **caractérisé en ce que**
la bande de support (4, 32) métallique, la couche fonctionnelle (14, 36) métallique et la couche intermédiaire (16, 34) métallique se présentent sous forme de bandes sans fin (4, 10, 12) déroulées avant l'assemblage, qui sont déroulées pour l'assemblage des couches afin de positionner les bandes (4, 14, 16) les unes par rapport aux autres, l'assemblage des bandes (4, 14, 16) ayant lieu par un laminage continu des bandes (4, 14, 16) entre des rouleaux (18).

6. Procédé selon l'une des revendications précédentes, **caractérisé en ce que** la bande de support (4, 32) assemblée avec la couche intermédiaire (16, 34) et la couche fonctionnelle (14, 36) est déroulée sous forme d'une bande sans fin (20).

7. Procédé selon l'une des revendications précédentes, **caractérisé en ce que** la bande de support (4, 32) est nettoyée avant l'assemblage avec les autres couches (14, 16, 34, 36), notamment de manière mécanique avec des brosses et/ou de manière chimique, de préférence, avant le dépôt de la couche intermédiaire (16, 34), où, de préférence, la bande (16) servant de couche intermédiaire (16, 34) et/ou la bande (14) servant de couche fonctionnelle (14, 36) sont également nettoyées avant l'assemblage, notamment de manière mécanique avec des brosses et/ou de manière chimique.

8. Utilisation d'un substrat créé avec un procédé selon l'une des revendications précédentes pour la mise en contact électrique de composants de puissance avec des fils de connexion (42) de préférence pour la réalisation de contact de courant faible.

9. Bande de support (20, 30) revêtue fabriquée avec un procédé selon l'une des revendications précédentes, **caractérisée en ce**
**qu'**une couche intermédiaire (16, 34) est disposée sur une bande de support (4, 32) constituée d'un alliage de laiton avec au moins 15 % en poids de zinc ou d'un alliage à base de cuivre contenant au moins 0,03 % en poids de titane, de chrome, de zirconium et/ou de cobalt et est fixée avec un procédé de placage par laminage et qu'une couche fonctionnelle (14, 36) constituée d'aluminium ou d'un alliage à base d'aluminium est disposée sur la couche intermédiaire (16, 34) et est fixée avec un procédé de placage par laminage, la couche intermédiaire (16, 34) étant complètement disposée entre la couche fonctionnelle (14, 36) et la bande de support (4, 32) métallique de sorte qu'il ne se produise aucune liaison de la couche fonctionnelle (14, 36) avec la bande de support (4, 32) métallique.

10. Bande de support (20, 30) selon la revendication 9, **caractérisée en ce que** la bande de support (4, 32) métallique est un alliage de laiton avec au moins 15 % en poids de zinc ou un alliage à base de cuivre contenant au moins 0,03 % en poids de titane, de chrome, de zirconium et/ou de cobalt.

11. Bande de support (20, 30) selon l'une des revendications 9 ou 10, **caractérisée en ce que**
la couche fonctionnelle (14, 36) métallique est de l'aluminium ou un alliage à base d'aluminium, est de préférence un alliage d'aluminium et de silicium.

12. Bande de support (20, 30) selon l'une des revendications 9 à 11, **caractérisée en ce que**
la couche intermédiaire (16, 34) métallique est du cuivre ou un alliage à base de cuivre ou du nickel ou un alliage à base de nickel.

13. Bande de support (20, 30) selon l'une des revendications 9 à 12, **caractérisée en ce que**
la bande de support (20, 30) revêtue est appropriée en tant que substrat pour la mise en contact électrique de composants de puissance avec des fils de connexion (42), de préférence pour la pour la réalisation de contact de courant faible.
